# EUROPEAN PATENT APPLICATION

(11) **EP 4 411 476 A1**
(43) Date of publication of application: **07.08.2024**
(21) Application number: 24155747.9
(22) Date of filing: 05.02.2024
(51) Int. Cl.: G03F 7/00, F21V 8/00, G03F 7/20, G03F 7/24

(54) **EXPOSURE UNIT WITH IMPROVED LIGHT INTENSITY UNIFORMNESS FOR EXPOSING A RELIEF PLATE PRECURSOR**

(30) Priority: 03.02.2023 NL 2034081
(71) Applicant: XSYS Prepress NV, 8900 Ieper (BE)
(72) Inventor: WATTYN, Bart Marc Luc, 8900 IEPER (BE); DE RAUW, Dirk Ludo Julien, 8900 IEPER (BE)
(74) Representative: Arnold & Siedsma

(57) **Abstract**

Exposure unit (10) for exposing a relief plate precursor, said exposure unit (10) comprising: a support structure (12) with a support surface (14) configured for supporting a relief plate precursor; a plurality of UV light sources (16) arranged next to each other and configured to emit UV light to a side of the relief plate precursor, said plurality of UV light sources (16) covering a light source area (LA) parallel to the support surface (14); and a light adjustment structure (20) configured to block and/or reflect a portion of the light emitted by the plurality of UV light sources (16) so as to render a light intensity measured in the support surface (14) more uniform as compared to a situation without the light adjustment structure (20); wherein the light adjustment structure (20) is arranged at least partially between the light source area (LA) and the support surface (14).

## Description

### Field of invention

The field of the invention relates to exposure units for exposing a relief plate precursor, and in particular to exposure units comprising UV light sources such as UV light tubes. The invention relates in particular to the field of exposing flexographic printing plate precursors.

### Background

Flexographic printing or letterpress printing are techniques which are commonly used for high volume printing. Flexographic or letterpress printing plate are relief plates with printing elements, typically called reliefs or dots, protruding above non-printing elements in order to generate an image on a recording medium such as paper, cardboard, films, foils, laminates, etc. Also, cylindrically shaped printing plates or sleeves may be used.

Various methods exist for making flexographic or letterpress printing plate precursors. According to conventional methods flexographic or letterpress printing plate precursors are made from multilayer substrates comprising a backing layer and one or more photocurable layers (also called photosensitive layers). Those photocurable layers are cured by exposure to electromagnetic radiation through a mask layer containing the image information or by direct and selective exposure to electromagnetic radiation *e.g.* by scanning of the plate to transfer the image information in order to obtain a relief plate. After curing the uncured parts are removed either by using liquids that are able to dissolve or disperse the uncured material or by thermal treatment in which the uncured material is liquefied and removed. Removal of the liquefied material may be achieved by adhesion or adsorption to a developer material or by application beams of solids, liquids or gases which may be heated. An alternative is to remove the material in the non-printing area by ablation using high power laser beams.

The relief precursor may be a precursor for an element selected from the group comprising: a flexographic printing plate, a relief printing plate, a letter press plate, an intaglio plate, a (flexible) printed circuit board, an electronic element, a microfluidic element, a micro reactor, a phoretic cell, a photonic crystal and an optical element, such as a Fresnel lens.

An exposure device for exposing a relief plate precursor comprises a source for electromagnetic radiation which delivers light with the required wavelength to the front or back side of a relief precursor. Preferably the wavelengths are in the UV-Vis region of the electromagnetic spectrum. The wavelength of the electromagnetic waves may be in the range from 200 to 800 nm, preferably in the range of 250 to 500 nm, more preferably in the range of 300 to 450 nm, most preferably in the range of 350 to 400 nm. The intensity of the electromagnetic radiation may range from 0.1 mW/cm² to 1000 mW/cm², preferably from 1 mW/cm² to 1000 mW/cm², more preferably from 10 mW/cm² to 1000 mW/cm², for example between 400 and 500 mW/cm² for front exposure and between 20 and 50 mW/m² for back exposure. As light sources metal halide lamps, fluorescent lamps, LEDs or flash lamps or combinations of several of these light sources may be used. Preferably, LEDs or fluorescent lamps are installed. The light sources can be connected to the control system which steers the exposure time, the wavelength in case light sources with different emission spectra are installed, the light intensity or combinations thereof. The light source and the plate precursor may be stationary during exposure or may be in relative motion to each other during exposure. Typically, the exposure is performed through a mask which may be an integral part of the plate precursor or a separate mask layer or an electronically switchable mask (e.g. a display like device with switchable transparent and non-transparent regions or pixels). Scanning beams without the use of a mask may be used as well. The exposure compartment may be used under ambient conditions or in specific atmosphere e.g. with reduced oxygen content.

Some exposure units comprise a support structure with a support surface for supporting a relief plate precursor, and a plurality of UV light sources configured to emit UV light to a side of the relief plate precursor. In classical exposure units UV light tubes are used. Different exposure results may be obtained on different parts of a relief plate precursor. This problem is for instance present during back exposure when the floor thickness of the same relief plate precursor is not uniform. This problem may also occur during front exposure with some parts of the precursor being sufficiently exposed and some other parts under-exposed. The printing results using the relief plate precursor thus obtained may accordingly be less optimal.

### Summary

An object of the present disclosure is to provide an exposure unit which exposes a relief plate precursor in an improved way.

According to a first aspect there is provided an exposure unit for exposing a relief plate precursor. The exposure unit comprises a support structure, a plurality of UV light sources and a light adjustment structure, such as a light adjustment structure. The support structure has a support surface configured for supporting a relief plate precursor. The plurality of UV light sources is arranged next to each other and configured to emit UV light to a side of the relief plate precursor. Said plurality of UV light sources covers a light source area parallel to the support surface. The light adjustment structure is configured to block and/or reflect a portion of the light emitted by the plurality of UV light sources so as to render a light intensity measured in the support surface more uniform as compared to a situation without the light adjustment structure. The light adjustment structure is arranged at least partially between the light source area and the support surface.

Thanks to the blocking and/or reflecting a portion of light emitted by the UV light sources, the light intensity at the support surface becomes more uniform. A more uniform light intensity distribution can be obtained over a larger area on the support surface, especially close to the edges of the light source area. The relief plate precursor can therefore be exposed in a more uniform manner. For instance, for back exposure the floor thickness may become more uniform in at least a part of the exposed relief precursor. In addition or alternatively, for front exposure the printing features may be exposed in a more uniform manner, obtaining a more uniform relief plate precursor. This improves the quality of the relief plate after a subsequent development step. Also, the light adjustment structure being interposed between the light source area and the support surface is able to influence more directly and more effectively the light intensity on the support surface from the UV light sources.

The exposure unit may have one or more of the following features, taking individually or according to any technically possible combinations.

Preferably, the UV light sources are elongated UV light tubes. An elongated UV light tube offers a large illumination area than some other types of UV light sources. Also, elongated UV light tubes are relatively inexpensive and easy to install. Using elongated UV light tubes therefore simplifies the operation and the maintenance of the exposure unit.

The plurality of UV light sources may be arranged to emit light in a main area and in at least one edge area adjacent the main area, said main area and said at least one edge area having together the same surface area as the light source area, and the light adjustment structure may be configured to block more light per surface area in the main area than in the at least one edge area. The plurality of UV light sources according to some embodiments emits light of a higher light intensity in the main area compared to the light intensity in the at least one edge area, because the light sources at the edges do not have neighbours on both sides but only have a neighbour on one side. By having a light adjustment structure blocking more light in the main area than in the edge area, the support surface may receive a more uniform light intensity.

Preferably, the light adjustment structure is configured to block at least 5%, preferably at least 10% more light per surface area in the main area than in the at least one edge area. According to the experiments carried out by the inventors blocking at least 5%, preferably at least 10% more light per surface area in the main area than in the at least one edge area can lead to a substantially uniform light intensity on an area of the support surface corresponding to a plate area of the support surface.

The at least one edge area may be a peripheral area which covers at least 10% of the surface area of the light source area. In this manner, at the support surface, less light intensity from a non-negligible part of the UV light sources is reduced compared to the light intensity from other parts of the UV light source. In this way a relief plate precursor covering a part of the edge area may be able to receive a light intensity which is approximately the same as the main area. The area of the light sources which can be used to homogeneously expose a relief plate precursor is therefore increased.

The UV light tubes may be arranged parallel to each other and extend in a tube direction, and the light adjustment structure may be configured to block more light in the main area than in two cross-tube edge areas extending in a cross-tube direction perpendicular to the tube direction, on either part of the main area. In this application 'block' can mean absorb at least a part of light and/or reflect at least a part of light which is emitted from the UV light sources away from the support surface. One of the main causes of light intensity variation within the plurality of UV light source is that the light intensity from a light tube varies in the tube direction. The middle of the light tube often emits a higher light intensity while the edge areas of the light tube emit a lower light intensity. By blocking more light in the main area than in the edge areas of the light tube, the support surface can have a more uniform light intensity in the tube direction.

The light adjustment structure may be configured to block more light in the main area than in two tube-length edge areas extending in the tube direction, on either part of the main area. Another cause of light intensity variation within the plurality of UV light sources is that the support surface receives a higher light intensity from a light tube in the main area compared to from a light tube farther from the main area in the cross-tube direction. By blocking more light in the main area than in two tube-length edge areas, the support surface can have a more uniform light intensity in the cross-tube direction as well. This further increases the part of the light sources that can be used to expose uniformly a relief plate precursor.

Preferably, the light adjustment structure comprises a grid structure extending between the plurality of UV light sources and the support surface. The grid structure typically comprises regular intervals of the parts which block light and the parts which let light through. With the grid structure, the proportion of light blocked compared to light let through can be controlled more easily and accurately.

The light adjustment structure may be a self-supporting mechanical structure.

The light adjustment structure may be made of a metal or plastic material.

The light adjustment structure may comprise a sheet metal in which apertures have been cut out. Producing such a sheet metal is simple, as it only requires apertures to be cut out without complicated manufacturing steps. The light intensity on the support surface can also be controlled more accurately as the size of the apertures can be calculated accurately before the sheet production.

The light adjustment structure may comprise a plurality of bridge structures, each bridge structure thereof being configured to be arranged over one or more UV light sources of said plurality of UV light sources, each bridge structure comprising apertures able to let through at least part of the light emitted by the one or more UV light sources and bridge sections able to block at least part of the light emitted by the one or more light source. The bridge structures for instance have a shape which is adapted to the shape of a light tube, so as to be able to partially surround a light tube. The bridge structure can thus be placed easily over the light sources. The bridge structures may be able to stand on their own without additional fixing element. In addition, the size of the apertures can be determined before producing the bridge structures, so how much light is let through by the bridge structure can be controlled in an accurate way.

The UV light tubes may be arranged parallel to each other and extend in a tube direction, and the apertures may have at least two different dimensions in the tube direction and/or the bridge sections between the apertures may have at least two different dimensions measured in the tube direction. In this way, different amounts of light in the tube direction can be blocked by the bridge structure. Where a greater amount of light needs to be blocked a smaller aperture and/or a wider bridge section (measured in the tube direction) is designed. Where a lower amount of light needs to be blocked a bigger aperture and/or a narrower bridge section (measured in the tube direction) is designed. With the help of the apertures of different dimensions and/or of the bridge sections of different dimensions, the UV light tubes which emit different light intensities in the tube direction can generate more uniform light intensity at the support surface.

The bridge structure may comprise a central portion and at least one peripherical portion as seen in the tube direction, the apertures of the central portion having a dimension in the tube direction smaller than the apertures of the at least one peripherical portion and/or the bridge sections between apertures of the central portion having a dimension in the tube direction bigger than the bridge sections between apertures of the at least one peripherical portion. In this manner, the central portion of the bridge structure blocks a greater amount of light than the peripherical portion. This is particularly suitable for the UV light tubes which emit a higher light intensity in the middle and a lower light intensity in the edge portions. In this way the part of the support surface corresponding to the central portion of the bridge structure and the part of the support surface corresponding to the peripheral portion of the bridge structure can have a closer light intensity.

The central portion may be configured to block at least 5%, preferably at least 10% more light per surface area than the at least one peripheral portion.

The plurality of bridge structures may comprise at least two different bridge structures configured to block a different amount of light. The support surface may receive two different light intensities from two UV light sources. With two different bridge structures these two different light sources can create a more uniform light intensity at the support surface.

The plurality of UV light sources may comprise at least one first edge light source, a plurality of central light sources and at least one second edge light source, said plurality of central light sources being arranged between the at least one first edge light source and the at least one second edge light source. At least one bridge structure placed over the at least one first edge light source and at least one bridge structure placed over the at least one second edge light source may be different from a plurality of bridge structures placed over the plurality of central light sources. The central light sources may generate a higher light intensity at the support surface than the first edge light source and/or the second edge light source. With at least one bridge structure placed over the first edge light source and at least one bridge structure placed over the second edge light source different from the bridge structures placed over the central light sources, the light intensity at the level of the support surface generated by the first and second edge light sources on one hand and the central light sources on the other can be adjusted differently to give a more uniform light intensity at the support surface.

The light adjustment structure may comprise a coating or a sticker or a foil arranged on the UV light sources. For example, a pattern of stripes may be arranged on a UV light tube. For example, the pattern of stripes may be a coating or paint which is printed on the UV tubes. Alternatively, thin metal foils or sheets may be arranged on the UV tubes, e.g., cylindrically shaped metal elements could be clipped or snapped on the tubes according to a determine pattern, wherein the pattern is such that more light is blocked in a main area as compared to at least one edge area.

The light adjustment structure may comprise at least one reflector configured to reflect at least a part of light emitted by the plurality of UV light sources towards the support surface. The reflector redirects a part of light from the UV light sources towards a plate area the support surface which would otherwise travel to locations outside the plate area. This reflection compensates the part of the support surface which would otherwise receive a lower light intensity so as to reach a more uniform light intensity at a plate area of the support surface.

The UV light tubes may be arranged parallel to each other and extend in a tube direction, and the at least one reflector may comprise at least one cross-tube reflector extending in a cross-tube direction perpendicular to the tube direction. More light from the middle of the UV light tubes reaches the support surface compared to light from the edge portions of the UV light tubes. By reflecting light from an edge portion of the light tubes towards a plate area of the support surface, compared with the case without any reflector, more light from the edge portion can reach the support surface, thereby rendering a more uniform light intensity at a plate area of the support surface.

The at least one reflector may comprise at least one tube-length reflector extending in the tube direction and arranged parallel to the UV light tubes. The tube-length reflector can reflect light travelling at least partially in the cross-tube direction towards the support surface.

The exposure unit may comprise a movable shutter or moveable curtain between the plurality of UV light sources and the support surface and the at least one cross-tube reflector may be movable, e.g. rotatable, such that it can be moved away when the moveable shutter or curtain is moved. The moveable shutter is for example configured to block UV light from reaching the support surface when the UV light sources have not reached their optimal work condition, for example during its warming up period when the light intensity increases gradually but has not reached the full output intensity yet. By having a moveable cross-tube reflector any potential interference between the moveable shutter and the cross-tube reflector can be avoided. For example, when the cross-tube reflector is in the way of the moveable shutter when the latter moves, the cross-tube reflector can be moved out of the path of the moveable shutter.

The at least one reflector may comprise at least one peripheral reflector and at least one internal reflector, said at least one peripheral reflector surrounding said at least one internal reflector, wherein an internal reflector reflects less light than a peripheral reflector. According to some embodiments less light from the periphery of the plurality of UV light sources reaches the support surface compared to light from a central portion of the plurality of UV light sources. With an internal reflector reflecting less light than a peripheral reflector, more light from the periphery of the UV light sources can be reflected to reach the support surface. This makes up the previously lower light intensity at an edge portion of the support surface and gives the support surface a more uniform light intensity. This is achieved for example by using an internal reflector smaller than the peripherical reflector.

Preferably, a variation of the light intensity in a plate area of the support surface is at most 10%, preferably at most 5%, said plate area corresponding with the light source area without a peripheral frame area extending at less than 15 cm from the periphery of the light source area.

Preferably, the exposure unit is configured for performing back exposure of the relief plate precursor. A back exposure of the relief place precursor typically requires a lower light intensity than the front exposure of the same relief plate precursor. Blocking a portion of light emitted by the UV light sources and reducing the light intensity on the support surface would not affect the results of back exposure.

Optionally, at least one of the plurality of UV light sources is dimmable.

Optionally, at least one of the plurality of UV light sources has an integrated reflector configured to reflect at least a part of light emitted by the UV light sources towards the support surface. The integrated reflector inside the UV light source(s) can redirect a part of light emitted and/or received by the UV light source(s) towards the support surface as an addition or an alternative to the light adjustment structure described above. This may render the light intensity at the support surface more uniform, for example by increasing the light intensity at a part of the support surface.

Optionally, the exposure unit further comprises an additional UV light source, at least a part of the support surface being located between the additional UV light source and the plurality of UV light sources. The plurality of UV light sources may be configured to carry out a back exposure of the relief plate precursor and the additional UV light source may be configured to carry out a main exposure of the relief plate precursor. The additional UV light source may comprise light-emitting diodes. The additional UV light source may be stationary or may be movable along the support surface. The additional UV light source may cover the entire plate area of the support surface or may a portion thereof. With this layout the exposure unit is able to perform both main exposure and back exposure of the relief plate precursor without having to turn around the relief precursor or having to use different machines for main and back exposure.

Preferably, the support structure comprises a transparent plate, and the plurality of UV light sources is arranged below the support structure. In an alternative embodiment, the support structure is a table and the exposure unit comprises a lid configured to be placed above the table, and the plurality of UV light sources and the light adjustment structure are arranged in the lid, the lid being moveable to a closed position in which the plurality of UV light sources is configured to expose a relief plate precursor placed on the table.

According to a second aspect there is also provided an exposure unit for exposing a relief plate precursor, said exposure unit comprising:
- a support structure with a support surface configured for supporting a relief plate precursor;
- a plurality of UV light sources arranged next to each other and configured to emit UV light to a side of the relief plate precursor, said plurality of UV light sources covering a light source area parallel to the support surface; and
- a light adjustment structure configured to block and/or reflect a portion of the light emitted by the plurality of UV light sources, the light adjustment structure being arranged at least partially between the plurality of UV light sources and the support surface,
wherein the plurality of UV light sources is arranged to emit light in a main area and in at least one edge area adjacent the main area, said main area and said at least one edge area having together the same surface area as the light source area, and wherein the light adjustment structure is configured to block more light per surface area in the main area than in the at least one edge area.

Any feature described in relation to the first aspect can be combined with the exposure unit of the second aspect.

### Brief description of the figures

The accompanying drawings are used to illustrate presently preferred non-limiting exemplary embodiments of the exposure unit of the present invention. The above and other advantages of the features and objects of the invention will become more apparent and the invention will be better understood from the following detailed description when read in conjunction with the accompanying drawings, in which:
Fig. 1A is a perspective view of an exposure unit according to an exemplary embodiment;
Fig. 1B is a detailed view of a part of the exposure unit in Fig. 1A;
Fig. 1C is a schematic cross-section view of an exposure unit similar to the exposure unit of Fig. 1A;
Fig. 2 is a perspective view of a first bridge structure according to an exemplary embodiment;
Fig. 3 is a perspective view of a second bridge structure according to an exemplary embodiment, the second bridge structure blocking a different amount of light than the first bridge structure;
Fig. 4 shows several light intensities at the support surface and of the light source with and without the mechanical structure;
Fig. 5 shows a side view of an exposure unit in the tube direction, the exposure unit comprising at least one reflector;
Fig. 6 is a side view of the exposure unit in Fig. 5 in the cross-tube direction;
Fig. 7 shows a top view of an exposure unit according to an exemplary embodiment, the exposure unit comprising a moveable shutter and at least a reflector;
Fig. 8 shows a top view of an exposure unit, comprising a tube-length reflector, a cross-tube reflector, and two internal reflectors;
Fig. 9 shows a perspective view of an exposure unit according to an embodiment of the disclosure.

### Detailed description of embodiments

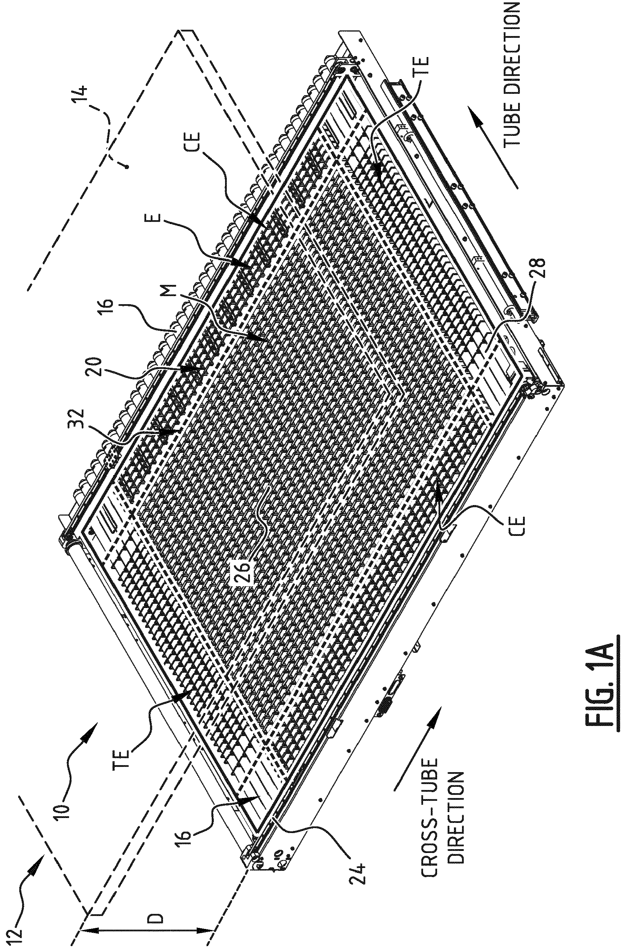

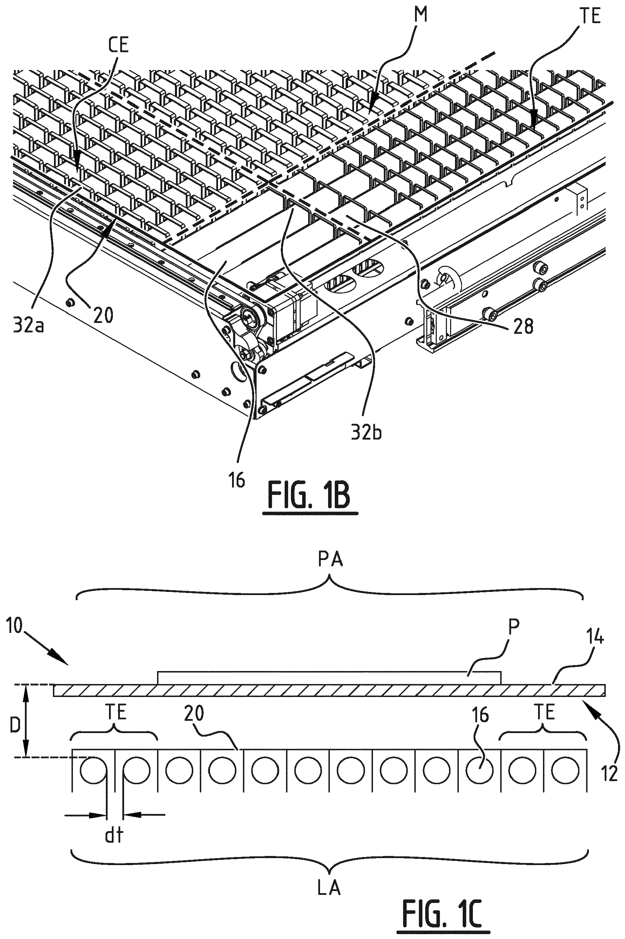

Figs. 1A - 1C show an exposure unit 10 for exposing a relief plate precursor P according to an exemplary embodiment of the present disclosure. The exposure unit 10 comprises a support structure 12 (see Fig. 1A and 1C), for example a transparent plate such as a glass plate, with a support surface 14 configured for supporting a relief plate precursor. The exposure unit 10 also comprises a plurality of UV light sources 16 configured to emit UV light to a side of the relief plate precursor. The exposure unit further comprises light adjustment structure, here a mechanical structure 20 configured to block and/or reflect a portion of the light emitted by the plurality of UV light sources 16 so as to render a light intensity measured in the support surface 14 more uniform as compared to a situation without the mechanical structure 20.

The plurality of UV light sources 16 are arranged next to each other. The distance between the centre of the UV light sources may be in the range of 20mm to 200mm, preferably in the range of 50mm to 100mm. According to some embodiments the UV light sources 16 are elongated UV light tubes. The elongated UV light tubes may have a diameter between 15mm to 50mm, preferably between 25mm and 45mm. The distance dt between the UV light tubes may be between 5mm and 100mm, preferably between 5mm and 50mm. According some embodiments the distance dt between the neighbouring UV light tubes depends on the distance D between the UV light tubes 16 and the support surface 14. The distance D between the top of the UV light sources 16 and the support surface 14 is for instance between 10cm and 25cm.

The elongated UV light tubes define a tube direction in their elongation direction. The elongation direction is typically straight. The elongated UV light tubes also define a cross-tube direction perpendicular to the tube direction. Preferably the UV light tubes are arranged parallel to each other and extend in the tube direction.

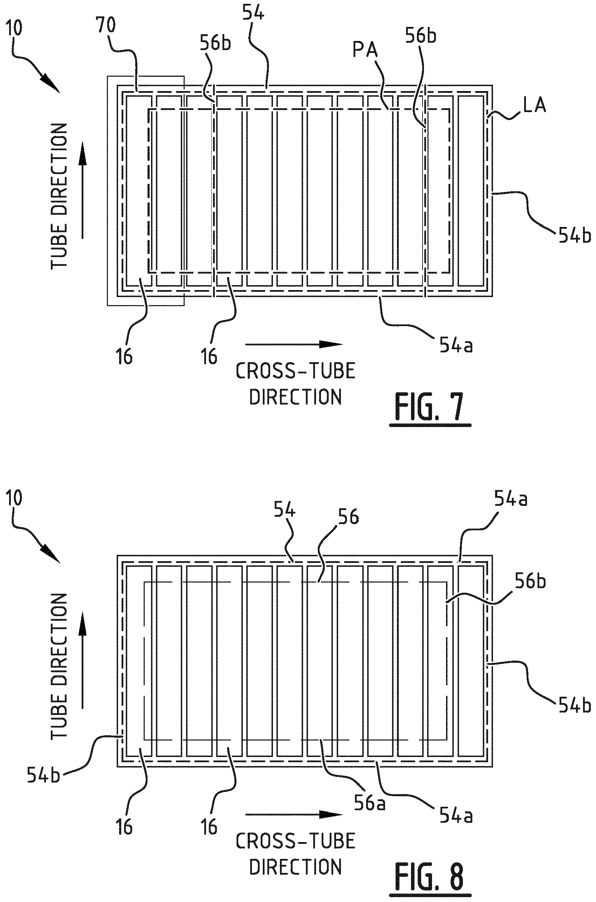

The plurality of UV light sources 16 covers a light source area LA (see Fig. 1C, and see further when discussing Fig. 7) parallel to the support surface 14. The light source area LA is for example a rectangle having the smallest size that can enclose the plurality of UV light sources 16.

The mechanical structure 20 is arranged at least partially between the light source area LA and the support surface 14. Between the light source area LA and the support surface 14 means located in a space between the support surface 14 and the light source area LA, i.e. between the light source area LA and the support surface 14 as seen in a direction perpendicular to the tube direction and the cross-tube direction, as seen in Fig. 1C.

The plurality of UV light sources 16 is arranged to emit light in a main area M and in at least one edge area E adjacent the main area M. Said main area M and said at least one edge area E have together the same surface area as the light source area LA. The at least one edge area E is for example located in the peripheral area around the main area M. The at least one edge area E may form a connected peripheral area which covers at least 10% of the surface area of the light source area LA. The connected peripheral edge area E comprises two cross-tube edge areas CE extending in the cross-tube direction perpendicular to the tube direction, on either part of the main area M. The edge area E also comprises two tube-length edge areas TE extending in the tube direction, on either part of the main area M. The two tube-length edge areas TE may have a total dimension in the cross-tube direction of less than 10%, preferable less than 7%, even more preferably less than 5% of the dimension of the light area LA in the cross-tube direction. The two tube-length edge areas TE have a total dimension which corresponds to at least twice the diameter of a UV light tube. The two cross-tube edge areas CE may have a total dimension in the tube direction of less than 15%, preferable less than 10%, even more preferably less than 8% of the dimension of the UV light tubes 16 in the tube direction.

Preferably, the mechanical structure 20 is configured to block more light per surface area in the main area M than in the peripheral edge area E. For example, the mechanical structure 20 is configured to block at least 5%, preferably at least 10% more light per surface area in the main area M than in the peripheral edge area E. More generally, the mechanical structure 20 may be configured to block more light in the main area M than in a cross-tube edge area CE and/or may be configured to block more light in the main area M than in a tube-length edge area TE. If no mechanical structure 20 is used, the intensity in the edge areas would be lower as compared to the main area; by using the mechanical structure 20 which blocks more light in the main area, this effect is compensated for, and the intensity is rendered more uniform.

According to some of the embodiments with a flatbed, the plurality of UV light sources 16 comprises at least one first edge light source 24, a plurality of central light sources 26, and at least one second edge light source 28. The plurality of central light sources 26 is arranged between the at least one first edge light source 26 and the at least one second edge light source 28. The central light sources 26 for instance correspond to the main area M. The at least one first edge light source 24 and/or the at least one second edge light source 28 for instance corresponds to the tube-length edge area TE.

Referring to Figs. 1 - 3, according to some embodiments, the mechanical structure 20 comprises a grid structure extending between the plurality of UV light sources 16 and the support surface 14. In addition or alternatively, the mechanical structure 20 comprises a sheet metal in which apertures have been cut out. The grid structure and/or the metal sheet preferably both blocks and reflects a portion of light emitted by the plurality of UV light sources 16, for example the grid structure and/or the metal sheet reflects a portion of light back to the plurality of UV light sources 16. This embodiment is particularly advantageous in combination with the integrated reflector in the UV light sources 16: light reflected back to the UV light sources 16 by the mechanical structure 20 can in this way be redirected by the integrated reflector towards the support surface 14 again.

The grid structure is for example made of aluminium. The distance between the grid structure and the UV light sources 16 is below 5 cm, more preferably below 3 cm, more preferably below 2 cm. This distance depends on the distance between the top of the UV light sources 16 and the support surface 14.

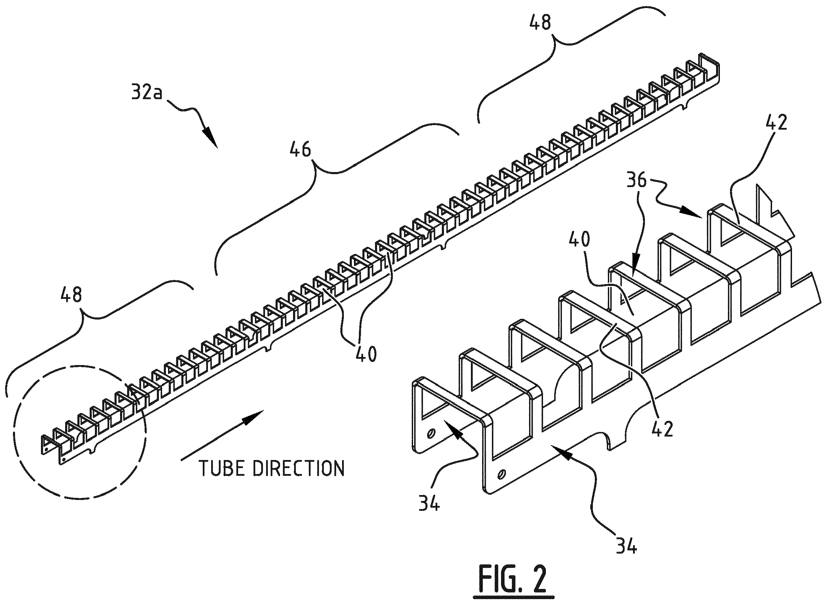

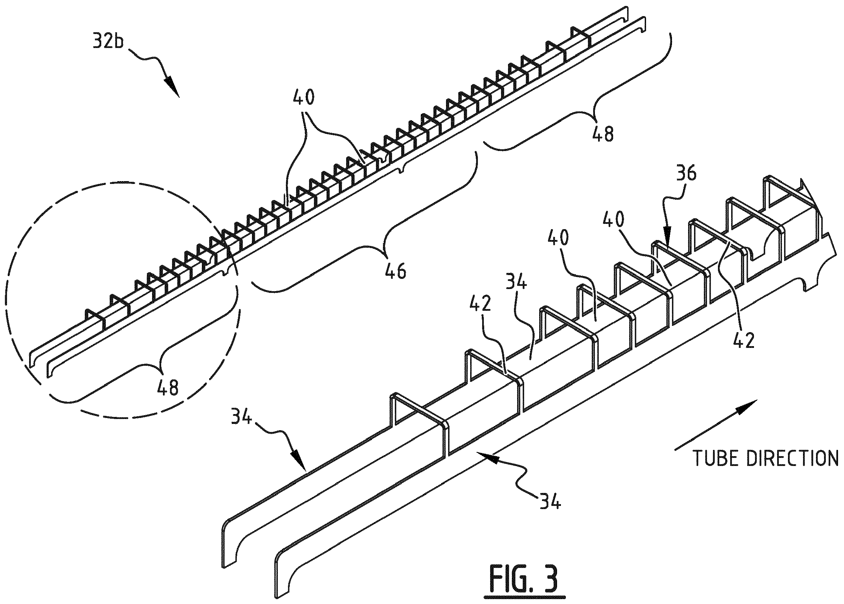

As shown in Fig. 1A and 1B, the mechanical structure 20 comprises a plurality of bridge structures 32. Figs. 1A, 1B, 2 and 3 show two types of bridge structures 32, as will be explained below. The bridge structure 32 is configured to be arranged over one of the plurality of UV light sources 16. In a non-illustrated embodiment, the bridge structure may be configured to be arranged over at least two UV light sources instead of one. As shown in Figs. 2 and 3, the bridge structure 32 for example comprises two lateral sides 34 and a cross-tube side 36 connecting the two lateral sides 34. At least one, typically two, of the lateral sides 34 is configured to be inserted between two elongated UV light tubes 16. The cross-tube side 36 is configured to be arranged at least partially between the UV light sources 16 and the support surface 14. The cross-tube side 36 is configured to block a portion of light emitted by at least a part of the plurality of UV light sources 16. The cross-tube side 36 may be configured to be arranged approximately parallel to the support surface 14, and the lateral sides 34 may be configured to be arranged approximately perpendicularly to the support surface 14.

The bridge structure 32 preferably blocks a portion of light emitted by the plurality of UV light sources 16 by reflecting it back towards the light sources 16. Optionally the bridge structure 32 may also absorb or partially absorb the light emitted on its surface.

The bridge structure 32, and in particular the cross-tube side 36, comprises apertures 40 able to let through at least a part of light emitted by one or more UV light sources 16. The bridge structure 32, and in particular the cross-tube side 36, also comprises bridge sections 42 between the apertures 40. The bridge sections 42 block at least a part of light emitted from the one or more UV light sources 16. According to some embodiments the bridge sections 42 are able at least partially to reflect light. At least a part of the apertures 40 is present on the cross-tube side 36 of the bridge structure 32, extending in the cross-tube direction. The apertures 40 may extend across the entire cross-tube side 36 in the cross-tube direction. Preferably, as shown in Figs. 2 and 3 the apertures 40 also extend across a part of the lateral sides 34. This allows a part of light emitted towards the lateral sides 36 also to reach the support surface 14.

The bridge section 42 may be in contact with at least one UV light source 16. Alternatively the distance between the bridge section 42 and at least one UV light source 16 is less than 5 cm, preferably less than 3 cm, more preferably less than 2 cm.

Preferably, as seen in Figs. 2 and 3 the apertures 40 have at least two different dimensions measured in the tube direction. In addition or alternatively, the bridge sections 42 have at least two different dimensions measured in the tube direction. The part with the apertures 40 having a greater dimension in the tube direction corresponds to the part of the support surface 14 which requires a lower reduction of light intensity. The part with the apertures 40 having a lower dimension in the tube direction corresponds to the part of the support surface 14 which requires a greater reduction of light intensity. More in particular, as shown, the bridge structure 32 comprises a central portion 46 and at least one peripherical portion 48 as seen in the tube direction. The apertures 40 of the central portion 46 have a dimension in the tube direction smaller than the apertures 40 of the at least one peripherical portion 48. In addition or alternatively, the bridge sections 42 between the apertures 40 of the central portion 46 have a dimension in the tube direction bigger than the bridge sections 42 between the apertures 40 of the at least one peripherical portion 48. According to the embodiments shown in Figs. 1 - 3 the bridge structure 32 comprises a central portion 46 sandwiched between two peripherical portions 48 as seen in the tube direction. The central portion 46 may be configured to block at least 5%, preferably at least 10% more light per surface area than the at least one peripheral portion 48.

Preferably, and as illustrated in Fig. 1A, at least one bridge structure 32 placed over the at least one first edge light source 24 and at least one bridge structure 32 placed over the at least one second edge light source 28 are different from a plurality of bridge structures 32 placed over the plurality of central light sources 26. Preferably, the plurality of bridge structures 32 comprises at least two different bridge structures configured to block a different amount of light. The bridge structures 32 for example comprise at least a first bridge structure 32a, shown in detail in Fig. 1B and Fig. 2, and a second bridge structure 32b, shown in Fig. 1B and Fig. 3. The first bridge structure 32a is configured to block more light than the second bridge structure 32b. According to the embodiment shown in Fig. 1, the first bridge structure 32a is configured to be placed over the central light sources 26. The second bridge structure 32b is configured to be placed over a tube-length edge area TE, for example over the at least one first edge light source 24 and the at least one second edge light source 28.

The central portion 46 of the first bridge structure 32a may be configured to block between 25% and 35% of light from the UV light sources 16, and the peripherical portion 48 of the first bridge structure 32a may be configured to block between 15% and 25% of light from the UV light sources 16. The transition from the central portion 46 of the first bridge structure 32a to the peripherical portion 48 is preferably gradual, which may be achieved by gradually varying the size of the apertures 40 and/or bridge sections 42, as seen in Fig. 2. As an alternative the central portion 46 of the first bridge structure 32a or of the second bridge structure 32b is configured to block between 15% and 25% light from the UV light sources 16, and the peripherical portion 48 of the first bridge structure 32a or of the second bridge structure 32b is configured to block between 5% and 15% of the light from the UV light sources 16.

The central portion 46 of the second bridge structure 32b may be configured to block between 5% and 15% of light from the UV light sources 16, and the peripherical portion 48 of the second bridge structure 32b may be configured to block between 0 and 5% of light from the UV light sources 16. The transition from the central portion 46 of the second bridge structure 32b to the peripherical portion 48 is preferably gradual, which may be achieved by gradually varying the size of the apertures 40 and/or bridge sections 42, as seen in Fig. 3.

The cross-sectional shape of the bridge structure 32 may be in the form of a V, a U such as a polygonal U or a circular U, or combinations thereof.

According to some embodiments the mechanical structure 20 is configured to render a light intensity measured in the support surface 14 more uniform as compared to a situation without the mechanical structure 20. Fig. 1C (see also Fig. 7 which will be discussed below) shows illustratively a rectangular plate area PA of the support surface 14 where a relief plate precursor P may be placed by an operator and where the light intensity is substantially uniform when a mechanical structure 20 is used.

Thanks to the mechanical structure 20, preferably, the variation of the light intensity, in a plate area PA of the support surface 14, is at most 10%, preferably at most 5%. Typically, the plate area PA corresponds with the light source area LA without a peripheral frame area extending at less than 15 cm from the periphery of the light source area LA.

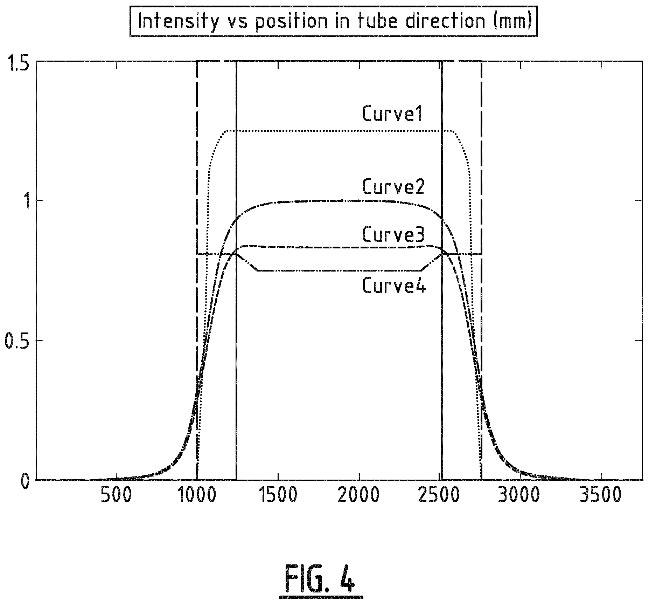

Fig. 4 shows the light intensity in the exposure unit 10 in function of the axial position, according to simulation and measurements. The X-axis (axial position) of Fig. 4 indicates the position in the tube direction. The Y-axis of Fig. 4 indicates the relative magnitude of the light intensity. The first pair of vertical lines which are closer one from the other indicates the dimension of a relief plate precursor placed on the support surface 14. The second pair of vertical lines (solid lines) which are farther one from the other and which encloses the first pair of vertical lines indicates the dimension of the light area in the tube direction. Four curves are shown in Fig. 4. Curve 1, which has the highest intensity in the area corresponding to the relief plate precursor, shows the intensity measured at the upper surface of the UV light tubes 16. Curve 2, which has the second highest intensity in the area corresponding to the relief plate precursor, corresponds to the measured light intensity at the support surface 14 without a mechanical structure according to the present disclosure. The result of Curve 2 is measured under the scenario where the support surface 14 is at a distance of 150mm from the UV light tubes 16. As can be seen, the intensity at the support surface 14 without the mechanical structure of the present disclosure is not uniform. The middle of the relief plate precursor is exposed at a higher light intensity than the edge portions of the relief plate precursor. Curve 4, which is the lowest in the middle amongst the four curves, represents the relative amount of light let through by the mechanical structure 20. The scale of Curve 4 is not identical as that of Curves 1 - 3. It can be seen that the mechanical structure 20 is configured to block more light in the main area M than in at least one edge area E. Curve 3 represents the simulated light intensity at the support surface 14 when there is a mechanical structure 20 according to the present disclosure in the exposure unit 10. Thanks to the mechanical structure 20, the light intensity on an area of the support surface 14 corresponding to the relief plate precursor is more uniform.

Although Fig. 4 illustrates the variation in the tube direction, it is understood that a similar pattern of variation may exist in the cross-tube direction.

In the illustrated embodiments the mechanical structure 20 is a separate self-supported structure arranged over the plurality of light sources 16. However, in other embodiments the mechanical structure may be integrated with the light sources. For example, the mechanical structure may comprise or consist of a coating, e.g. a paint, arranged on the transparent or translucent tubes of the UV light tubes and configured to block a portion of the light emitted by the corresponding light source. The coating may be arranged according to a grid-like pattern, e.g. a pattern similar to the pattern of the bridge structures described above, wherein stripes of coating are arranged at a distance of each other on the tubes. In another embodiment, a patterned sticker or foil may be arranged on a UV light source. The sticker or foil may be provided with a pattern of apertures in a similar manner as the pattern that was described above for the bridge structures. The foil may be configured to be clipped onto and fixed to the UV light tube(s).

In the illustrated embodiment of Figs. 1A-1C, the exposure unit 10 is a flatbed exposure unit. The support surface 14 is flat and is configured for supporting flat relief plate precursors P. According to another embodiment (not shown), the exposure unit may be an exposure unit of a drum layout. The support surface is cylindrical and is for example configured for supporting relief plate precursors in the form of a sleeve or a part of a sleeve. The cylindrical support surface on which the relief plate precursors are fixed is for example rotatable. In such an embodiment, the elongated UV light tubes may be arranged along the circumference of a cylinder, the circumferential direction of the cylinder being the cross-tube direction. The edge area E may comprise two cross-tube edge areas CE extending in a cross-tube direction (i.e. the circumferential direction of the drum) on either part of a main area M. When the UV light sources 16 are not arranged along the entire circumferential direction, the edge area E may also comprise tube-length edge areas TE. However, those may be omitted when the UV light sources 16 are arranged approximately along the entire circumferential direction.

Preferably the UV light sources 16 are configured to emit UV light to a backside of a relief plate precursor to carry out back exposure. Alternatively or in addition the UV light sources 16 are configured to emit UV light to a front side of a relief plate precursor to carry out front exposure. The illustrated embodiment of Fig. 1A-1C is typically used for back exposure but could also be used for front exposure. In the embodiment of Figs. 1A-1C, the plurality of UV light sources 16 is arranged below the support structure 12 and illuminates the relief plate precursor from below, but in other embodiments (not shown), the plurality of UV light sources may be arranged above the support structure 12 and illuminate the relief plate precursor from above. In such embodiment, the plurality of UV light sources may be arranged in a lid which can be put over the relief precursor.

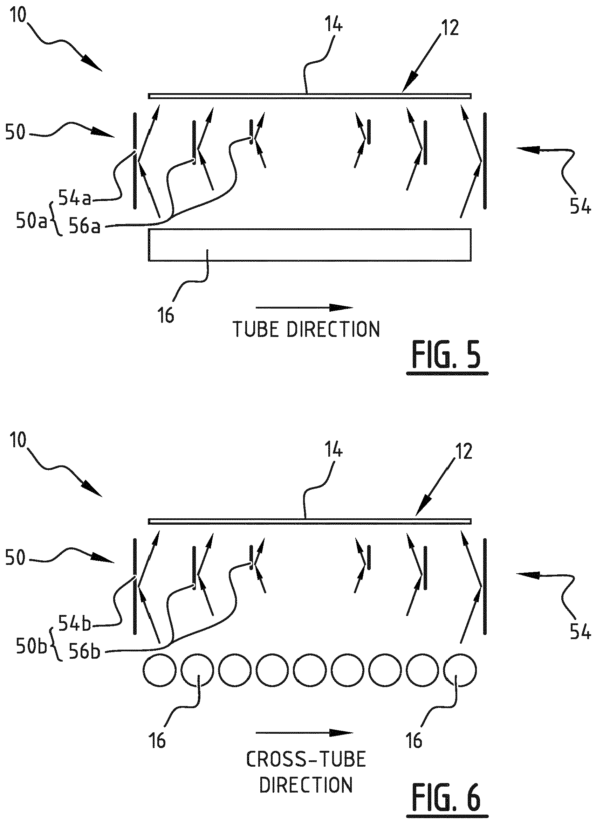

Now referring to Figs. 5 - 8, in addition to or as an alternative to the embodiments where the mechanical structure 20 comprises a grid structure and/or a sheet of metal and/or a plurality of bridge structures as described above, the mechanical structure 20 may comprise at least one reflector 50 configured to reflect at least a part of light emitted by the plurality of UV light sources 16 towards the support surface 14. The reflector 50 is for example a mirror.

According to some embodiments, such as the one in Fig. 5, the at least one reflector 50 comprises at least one cross-tube reflector 50a extending in the cross-tube direction. According to some embodiments at least one cross-tube reflector 50a is arranged at first ends of the UV light tubes in the tube direction. According to some embodiments the cross-tube reflectors 50a are arranged at both ends of the UV light tubes in the tube direction, as seen in Fig. 5. In addition or alternatively, at least one cross-tube reflector 50a is arranged at least partially between the UV light sources 16 and the support surface 14.

In addition or alternatively, as shown in Fig. 6 the at least one reflector 50 comprises at least one tube-length reflector 50b extending in the tube direction and arranged parallel to the UV light tubes.

According to some embodiments the mechanical structure 20 comprises a reflector which is arranged at least partially between the plurality of UV light sources 16 and the support surface 14. Some examples of the location are shown by the internal cross-tube reflector 56a and internal tube-length reflector 56b in Figs. 5 and 6. Between the plurality of UV light sources 16 and the support surface 14 means located in a space between the support surface 14 and the light source area LA in a direction perpendicular to the tube direction and the cross-tube direction. In addition or alternatively, the mechanical structure 20 comprises a reflector which is at least partially located outside a space between the plurality of UV light sources 16 and support surface 14. Some examples of the location are shown by the peripheral cross-tube reflector 54a and peripherical tube-length reflector 54b in Figs. 5 and 6.

As shown in Figs. 7 and 8, the at least one reflector 50 may comprise at least one peripheral reflector 54 located at a periphery of the plurality of UV light sources 16. The peripherical reflector 54 for example comprises at least one peripheral cross-tube reflector 54a and/or at least one peripherical tube-length reflector 54b. The peripheral cross-tube reflector 54a preferably extends the entire length of the UV light sources 16 in the cross-tube direction. The peripheral tube-length reflector 54b preferably extends the entire length of the UV light sources 16 in the tube direction.

In addition or alternatively, the at least one reflector 50 comprises at least one internal reflector 56, see Fig. 7. The internal reflector 56 is arranged between a top surface of the UV light sources 16 (the top surface is a surface tangent to the upper surface of the plurality of UV light sources 16, the top surface facing the support surface 14) and the support surface 14. The internal reflector 56 for example comprises at least one internal cross-tube reflector 56a and/or at least one internal tube-length reflector 56b for example located at a location between two UV light sources 16 projected on the support surface 14. According to some embodiments the at least one peripheral reflector 54 surrounds at least one internal reflector 56, as seen in Fig. 8. The internal cross-tube reflector 56a preferably only extends a part of the entire length of UV light sources 16 in the cross-tube direction. The internal tube-length reflector 56b extends the entire width (see Fig. 7) or only a part of the entire width (see Fig. 8) of the UV light sources 16 in the tube direction.

Preferably an internal reflector 56 (the internal cross-tube reflector 56a and/or the internal tube-length reflector 56b respectively) reflects less light than a peripheral reflector 54 (the peripheral cross-tube reflector 54a and/or at least one peripherical tube-length reflector 54b respectively). This is for example achieved by having an internal reflector 56 having a lower height (measured in a height direction perpendicular to the tube direction and to the cross-tube direction) than the peripherical reflector 54. Preferably the distance between the internal reflector 56 and the support surface 14 is less than five centimetres, preferably less than three centimetres, more preferably less than one centimetre.

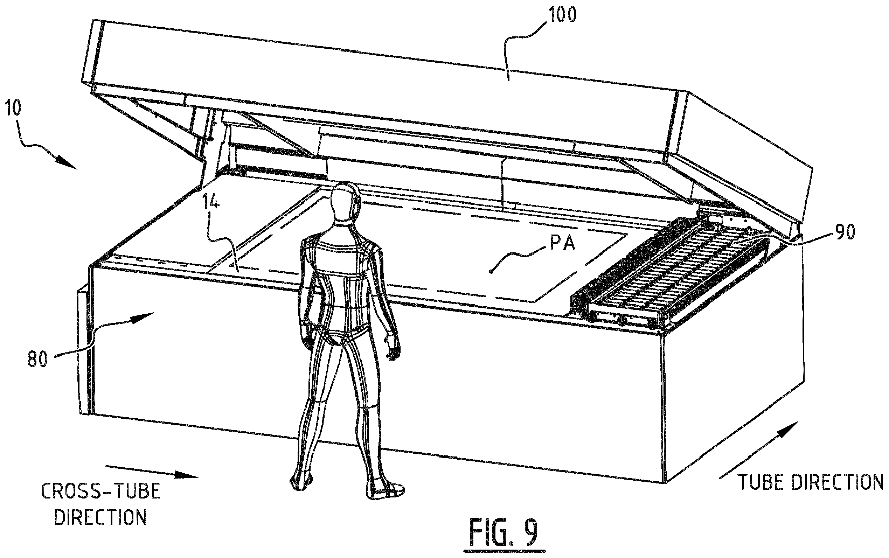

Fig. 9 illustrates another embodiment of an exposure unit 10 with a housing 80. The plurality of UV light sources 16 and the mechanical structure 20 are arranged in the housing 80. An upper surface 14 of the housing may be a glass plate which form the support structure for a relief plate precursor. The plate may be placed in a plate area PA on the support surface 14. Preferably, the exposure unit 10 further comprises an additional UV light source 90 outside the housing 80. The support surface 14 is located between at least a part of the additional UV light source 90 and the UV light sources 16. The plurality of UV light sources 16 is configured to carry out a back exposure of the relief plate precursor P and the additional UV light source 90 is configured to carry out a main exposure of the relief plate precursor P. The additional UV light source 90 extends in the tube direction, preferably covers substantially the dimension of the support surface 14 in the tube direction, and is moveable in the cross-tube direction. Alternatively, the additional UV light source 90 is stationary during main exposure and extends over the entire plate area PA. Optionally, the exposure unit 10 comprises a lid 100. The lid 100 is moveable relative to the housing 80, for example rotatable relative to the housing 80. The lid 100 is movable between an open position (seen in Fig. 9) in which a relief plate precursor P can be placed on the support surface 14 and a closed position in which the exposure unit 10 exposes the relief plate precursor P. Preferably the additional UV light source 90 comprises or consists of light-emitting diodes.

Alternatively, the exposure unit 10 of Fig. 9 does not comprise the additional UV light source for main exposure and only comprises the plurality of UV light sources 16 described above in the housing 80 for back exposure.

According to another embodiment (not illustrated) the exposure unit comprises a housing and a lid. The plurality of UV light sources 16 and the mechanical structure 20 are arranged in the lid of the exposure unit.

According to another embodiment (not illustrated), there may be provided a stationary additional UV light source for the main exposure in combination with a plurality of stationary UV light sources 16 as illustrated in Fig. 1A for the back exposure, and the relief plate precursor P may be transported along the support surface 14, for example on a transport belt, between the additional UV light source and the UV light sources 16.

According to any of the embodiments described above, the exposure unit 10 may comprise a moveable shutter 70 (only shown in Fig. 7, but may also be present in the embodiment of Figs. 1A-1C) between the plurality of UV light sources 16 and the support surface 14. The moveable shutter 70 is configured to block at least partially light emitted from the plurality of UV light sources 16 from reaching the support surface 14, for example when the UV light sources 16 have not yet reached their stable working condition (for example during the warming-up period of the UV light sources when the UV light sources have not yet reached their maximal output intensity). The moveable shutter 70 is moveable in the cross-tube direction. Fig. 7 shows a stage during the movement of the moveable shutter 70. At the end of the movement of the moveable shutter or curtain, the UV light sources 16 are completely shielded so that no light can reach the precursor. The at least one cross-tube reflector 50a may be movable, for example rotatable or displaceable, such that it can be moved away when the moveable shutter 70 is moved.

In any embodiment described above, at least one of the plurality of UV light sources 16 may be dimmable. For example, each light source may be individually dimmable or groups of light sources may be dimmable.

In any embodiment described above, the UV light sources 16 may be elongated fluorescent tubes configured to emit UV light. According to one embodiment the UV light sources 16 are elongated tubes with LEDs configured to emit UV light. According to one embodiment the UV light sources 16 comprise arc lamps, such as high pressure mercury lamps.

In any embodiment described above, at least one of the plurality of UV light sources 16 may have an integrated reflector (not shown in the Figures) configured to reflect at least a part of light emitted by and/or received by the UV light sources 16 towards the support structure 12. The integrated reflector is for example a coating on the lower inner half of the (for example transparent) wall of the UV light sources 16, for example on the lower half of the elongated UV light tubes facing away the support surface 14.

In any embodiments described above, the plurality of UV light sources 16 is for example configured to generate a light intensity of 15 - 50 mW/cm² on the support surface 14, when the UV light sources 16 are used for back exposure. For front exposure the values could be much higher. For example, the plurality of UV light sources 16 may be configured to generate a light intensity of 20 - 45 mW/cm² on the support surface 14 measured using Ophir Starlite with sensor PD300RM-UV.

Whilst the principles of the invention have been set out above in connection with specific embodiments, it is to be understood that this description is merely made by way of example and not as a limitation of the scope of protection which is determined by the appended claims.

## Claims

1. An exposure unit (10) for exposing a relief plate precursor, said exposure unit (10) comprising:
- a support structure (12) with a support surface (14) configured for supporting a relief plate precursor;
- a plurality of UV light sources (16) arranged next to each other and configured to emit UV light to a side of the relief plate precursor, said plurality of UV light sources (16) covering a light source area (LA) parallel to the support surface (14); and
- a light adjustment structure (20) configured to block and/or reflect a portion of the light emitted by the plurality of UV light sources (16) so as to render a light intensity measured in the support surface (14) more uniform as compared to a situation without the light adjustment structure (20); wherein the light adjustment structure (20) is arranged at least partially between the light source area (LA) and the support surface (14).

2. The exposure unit (10) of claim 1, wherein the UV light sources (16) are elongated UV light tubes.

3. The exposure unit (10) of any one of the previous claims, wherein the plurality of UV light sources (16) is arranged to emit light in a main area (M) and in at least one edge area (E) adjacent the main area (M), said main area (M) and said at least one edge area (E) having together the same surface area as the light source area (LA), and wherein the light adjustment structure (20) is configured to block more light per surface area in the main area (M) than in the at least one edge area (E).
wherein preferably the light adjustment structure (20) is configured to block at least 5%, preferably at least 10% more light per surface area in the main area (M) than in the at least one edge area (E);
wherein preferably at least one edge area (E) is a peripheral area which covers at least 10% of the surface area of the light source area (LA).

4. The exposure unit (10) of claim 2 and claim 3, wherein the UV light tubes are arranged parallel to each other and extend in a tube direction, and wherein the light adjustment structure (20) is configured to block more light in the main area (M) than in two cross-tube edge areas (CE) extending in a cross-tube direction perpendicular to the tube direction, on either part of the main area (M);
wherein preferably the light adjustment structure (20) is configured to block more light in the main area (M) than in two tube-length edge areas (TE) extending in the tube direction, on either part of the main area (M).

5. The exposure unit (10) of any one of the previous claims, wherein the light adjustment structure (20) comprises a grid structure extending between the plurality of UV light sources (16) and the support surface (14); and/or
wherein the light adjustment structure (20) comprises a sheet metal in which apertures have been cut out.

6. The exposure unit (10) of any one of the previous claims, wherein the light adjustment structure (20) comprises a plurality of bridge structures (32), each bridge structure (32) thereof being configured to be arranged over one or more UV light sources of said plurality of UV light sources (16), each bridge structure (32) comprising apertures (40) able to let through at least part of the light emitted by the one or more UV light sources (16) and bridge sections (42) able to block at least part of the light emitted by the one or more light sources (16).

7. The exposure unit (10) of claims 2 and 6, wherein the UV light tubes are arranged parallel to each other and extend in a tube direction, and wherein the apertures (40) have at least two different dimensions measured in the tube direction and/or wherein the bridge sections (42) between the apertures (40) have at least two different dimensions measured in the tube direction;
wherein preferably the bridge structure (32) comprises a central portion (46) and at least one peripherical portion (48) as seen in the tube direction, the apertures (40) of the central portion (46) having a dimension in the tube direction smaller than the apertures (40) of the at least one peripherical portion (48) and/or the bridge sections (42) between apertures (40) of the central portion (46) having a dimension in the tube direction bigger than the bridge sections (42) between apertures (40) of the at least one peripherical portion (48);
, wherein preferably the central portion (46) is configured to block at least 5%, preferably at least 10% more light per surface area than the at least one peripheral portion (48).

8. The exposure unit (10) of claim 6 or 7, wherein the plurality of bridge structures (32) comprises at least two different bridge structures (32a, 32b) configured to block a different amount of light; and/or
wherein the plurality of UV light sources (16) comprises at least one first edge light source (24), a plurality of central light sources (26) and at least one second edge light source (28), said plurality of central light sources (26) being arranged between the at least one first edge light source (24) and the at least one second edge light source (28), and wherein at least one bridge structure (32) placed over the at least one first edge light source (24) and at least one bridge structure (32) placed over the at least one second edge light source (28) are different from a plurality of bridge structures (32) placed over the plurality of central light sources (26).

9. The exposure unit (10) of claim 2 and any one of the previous claims, wherein the light adjustment structure (20) comprises a coating or sticker or foil arranged on the plurality of UV light tubes.

10. The exposure unit (10) of any one of the previous claims, wherein the light adjustment structure (20) comprises at least one reflector (50) configured to reflect at least a part of light emitted by the plurality of UV light sources (16) towards the support surface (14);
wherein optionally the UV light tubes are arranged parallel to each other and extend in a tube direction, and wherein the at least one reflector (50) comprises at least one cross-tube reflector (50a) extending in a cross-tube direction perpendicular to the tube direction.

11. The exposure unit (10) of claim 10, wherein the at least one reflector (50) comprises at least one tube-length reflector (50b) extending in the tube direction and arranged parallel to the UV light tubes;
said exposure unit optionally comprising a moveable shutter (70) between the plurality of UV light sources (16) and the support surface (14) and wherein the at least one tube-length reflector (50a) is movable, e.g. rotatable, such that it can be moved away when the moveable shutter (70) is moved.

12. The exposure unit (10) of claim 10 or 11, wherein the at least one reflector (50) comprises at least one peripheral reflector (54) and at least one internal reflector (56), said at least one peripheral reflector (54) surrounding said at least one internal reflector (56), wherein an internal reflector (56) reflects less light than a peripheral reflector (54).

13. The exposure unit (10) of any one of the previous claims, wherein a variation of the light intensity in a plate area (PA) of the support surface (14) is at most 10%, preferably at most 5%, said plate area (PA) corresponding with the light source area (LA) without a peripheral frame area extending at less than 15 cm from the periphery of the light source area (LA).

14. The exposure unit (10) of any one of the previous claims, wherein the exposure unit (10) is configured for performing back exposure of the relief plate precursor; and/or
wherein at least one of the plurality of UV light sources (16) is dimmable; and/or
wherein at least one of the plurality of UV light sources (16) has an integrated reflector configured to reflect at least a part of the light emitted by and/or received by the UV light sources (16) towards the support structure (12).

15. The exposure unit (10) of any one of previous claims, further comprising an additional UV light source (90), at least a part of the support surface (14) being located between the additional UV light source (90) and the plurality of UV light sources (16), the plurality of UV light sources (16) being configured to carry out a back exposure of the relief plate precursor and the additional UV light source (90) being configured to carry out a main exposure of the relief plate precursor;
wherein preferably the additional UV light source (90) comprises light-emitting diodes;
wherein preferably the additional UV light source is movable along the support surface.

16. The exposure unit (10) of any one of the previous claims, wherein the support structure comprises a transparent plate, and the plurality of UV light sources is arranged below the support structure; or
wherein the support structure is a table and wherein the exposure unit comprises a lid configured to be placed above the table, and wherein the plurality of UV light sources (16) and the light adjustment structure (20) are arranged in the lid, the lid being moveable to a closed position in which the plurality of UV light sources (16) is configured to expose a relief plate precursor placed on the support surface (14).
